# EUROPEAN PATENT SPECIFICATION

(11) **EP 4 338 210 B1**
(45) Date of publication and mention of the grant of the patent: **14.10.2026**
(21) Application number: 22721450.9
(22) Date of filing: 29.04.2022
(51) Int. Cl.: H10N 10/13, H10N 10/17

(54) **THERMOELECTRIC MODULE**
THERMOELEKTRISCHES MODUL
MODULE THERMOÉLECTRIQUE

(30) Priority: 10.05.2021 GR 20210100315; 13.09.2021 GB 202112997
(43) Date of publication of application: 20.03.2024
(73) Proprietor: European Thermodynamics Limited, Leicestershire LE8 0RX (GB)
(72) Inventor: TULEY, Richard, Kibworth, Leicestershire LE8 0RX (GB); STEFANAKI, Eleni-Chrysanthi, Kibworth, Leicestershire LE8 0RX (GB)
(74) Representative: Barker Brettell LLP
(86) International application number: PCT/GB2022/051105
(87) International publication number: WO 2022/238679

(56) References cited:
- WO-A2-2007/109368
- JP-A- 2002 232 028
- JP-A- 2018 032 685
- US-A1- 2009 025 770

## Description

The present disclosure relates to a thermoelectric module and a method of manufacture of a thermoelectric module.

Thermoelectric modules may be used as an electrically powered heat pump for temperature control including cooling and heating, or they may be used as a power generator by utilising a heat flux.

Standard thermoelectric modules have little tolerance to failure of a single part within them. For example, since the thermoelectric elements in standard thermoelectric modules are connected in series, an open circuit failure of any one element causes complete failure of the whole module. A more fault resistant module would lead to an improved reliability, lifetime and manufacturing yield.

US3632451 discloses a thermoelectric module having parallel circuits interconnected at equal potential points, each parallel circuit comprising a number of thermoelectric couples (thermocouples) connected electrically in series. This provides tolerance to failure of any one component of the circuit.

JP2002232028 discloses a thermoelectric module using parallelisation of the thermoelectric elements using the interconnects on a substrate.

WO2019132124A1 discloses a thermoelectric module using parallelisation of some series connected strings of thermoelectric elements within a module.

Standard thermoelectric modules use electrically insulating substrates which have different thermal expansion coefficients to the electrical interconnects. This can cause bowing and warping of the substrate either during its formation process, during module assembly or during operation. This can have a detrimental impact on the module yield, module lifetime and the good thermal interface required between a module and the surrounding system.

US20090025770A1 discloses a substrate which can have interconnects on one side to connect to the thermoelectric elements and a heat conductor element or fin pads on the outside. These fin pads help control the position of substrate bending that occurs due to temperature differences across the module when in operation.

In slide 11 of the conference presentation, Bartholomé K., Heuer J., Horzella J., Jägle M., König J., Tarantik K., 2014, Thermoelectric modules built with new high temperature materials, IAV 2014, Berlin, Germany, modules are disclosed with the same interconnect structure on the outer face of the substrate as on the inner face.

A first aspect provides a thermoelectric module comprising:
a first electrically-insulating substrate having a first face and a second face opposite the first face, wherein a first plurality of electrical interconnects is disposed in a first pattern on the first face;
a second electrically-insulating substrate spaced from the first electrically-insulating substrate and having a first face facing the first face of the first electrically-insulating substrate, wherein a second plurality of electrical interconnects is disposed in a second pattern on the first face of the second electrically-insulating substrate;
a plurality of thermoelectric elements comprising n-type thermoelectric elements and p-type thermoelectric elements disposed between the first electrically-insulating substrate and the second electrically-insulating substrate, wherein each thermoelectric element extends from one of the first plurality of electrical interconnects to one of the second plurality of electrical interconnects, wherein the thermoelectric elements are arranged to form a first series-connected string of alternating n-type and p-type thermoelectric elements and a second series-connected string of alternating n-type and p-type thermoelectric elements and at least one of the n-type or p-type thermoelectric elements in the first series-connected string is electrically connected in parallel with one of the thermoelectric elements of the same type (n-type or p-type) in the second series-connected string; and
one or more regions of metallic material are disposed in a third pattern on the second face of the first electrically-insulating substrate;
wherein at least one of the parallel connections is via one of the first plurality of interconnects.

At least one pair of thermoelectric elements comprising a thermoelectric element in the first series-connected string and a thermoelectric element of the same type in the second series-connected string that are electrically connected in parallel may be disposed at or in the vicinity of a corner or corner region of the first electrically-insulating substrate and/or the second electrically-insulating substrate.

At least one pair of thermoelectric elements comprising a thermoelectric element in the first series-connected string and a thermoelectric element of the same type in the second series-connected string that are electrically connected in parallel may be disposed at or in the vicinity of an edge or edge region of the first electrically-insulating substrate and/or the second electrically-insulating substrate.

Every thermoelectric element in the first series-connected string may be electrically connected in parallel with one of the thermoelectric elements of the same type in the second series-connected string.

In an example implementation, not every thermoelectric element in the first series-connected string may be electrically connected in parallel with one of the thermoelectric elements of the same type in the second series-connected string. One or more of the thermoelectric elements in the first series-connected string may not be electrically connected in parallel with one of the thermoelectric elements of the same type in the second series-connected string.

For instance, up to 5%, up to 10%, up to 20%, up to 30%, up to 40%, up to 50%, up to 60%, up to 70%, up to 80%, up to 90% or up to 95% of the thermoelectric elements in the first series-connected string may each be electrically connected in parallel with one of the thermoelectric elements of the same type in the second series-connected string.

For instance, at least 5%, at least 10%, at least 20%, at least 30%, at least 40%, at least 50%, at least 60%, at least 70%, at least 80%, at least 90% or at least 95% of the thermoelectric elements in the first series-connected string may each be electrically connected in parallel with one of the thermoelectric elements of the same type in the second series-connected string.

Within the first series-connected string, there may be one or more regions where not every thermoelectric element is electrically connected in parallel with one of the thermoelectric elements of the same type in the second series-connected string, i.e. there may be one or more regions within the first series-connected string where one or more thermoelectric elements are not electrically connected in parallel with one of the thermoelectric elements of the same type in the second series-connected string. For example, there may be one or more regions within the first series-connected string where every second thermoelectric element, every third thermoelectric element, every fourth thermoelectric element, every fifth thermoelectric element or every sixth thermoelectric element is electrically connected in parallel with one of the thermoelectric elements of the same type in the second series-connected string.

The third pattern may be similar to or substantially the same as the first pattern.

The third pattern may have an area fraction on the second face of the first electrically-insulating substrate that is smaller than, the same as or larger than an area fraction of the first pattern on the first face of the first electrically-insulating substrate.

One or more regions of metallic material may be disposed in a fourth pattern on a second face opposite the first face of the second electrically-insulating substrate.

The fourth pattern may be similar to or substantially the same as the second pattern.

The fourth pattern may have an area fraction on the second face of the second electrically-insulating substrate that is smaller than, the same as or larger than an area fraction of the second pattern on the first face of the second electrically-insulating substrate.

At least one of the first plurality of electrical interconnects and/or at least one of the second plurality of electrical interconnects may be connected to two or more n-type thermoelectric elements and two or more p-type thermoelectric elements.

At least one of the first plurality of electrical interconnects and/or at least one of the second plurality of electrical interconnects may be rectangular, e.g. square, in shape, and connected to two n-type thermoelectric elements and two p-type thermoelectric elements with the thermoelectric elements being connected to the electrical interconnect(s) at or close to the corners of the rectangular, e.g. square, electrical interconnect(s).

The first substrate and/or the second substrate may be made up of two or more substrate parts.

The first substrate and/or the second substrate may be made up of at least two rows of substrate parts.

The first substrate and/or the second substrate may be made up of up to five rows of substrate parts.

The first substrate and/or the second substrate may be made up of at least two columns of substrate parts.

The first substrate and/or the second substrate may be made up of up to five columns of substrate parts.

The thermoelectric module may be connected to an external system by a mounting plate connected to the third pattern on the second surface of the first electrically-insulating substrate.

The mounting plate may comprise or may be a part of: an item requiring heating or cooling; a thermally conductive block; or a heat transfer device such as a heat sink or a heat exchanger.

When the first electrically-insulating substrate experiences a temperature change during operation, the presence of the one or more regions of metallic material disposed in the third pattern on the second face of the first electrically-insulating substrate may help to minimise or prevent warping, e.g. bowing, by offsetting or balancing forces on the two faces of the first electrically-insulating substrate.

When the second electrically-insulating substrate experiences a temperature change during operation, the presence of the one or more regions of metallic material disposed in the fourth pattern on the second face of the second electrically-insulating substrate may help to minimise or prevent warping, e.g. bowing, by offsetting or balancing forces on the two faces of the second electrically-insulating substrate.

The presence of the third pattern can reduce bowing of the first electrically-insulating substrate due to the different thermal expansion coefficients of the first plurality of electrical interconnects and the first electrically-insulating substrate. Bowing of the first electrically-insulating substrate may be particularly well reduced in embodiments, in which the third pattern is similar to or substantially the same as the first pattern.

The presence of the fourth pattern can reduce bowing of the second electrically-insulating substrate due to the different thermal expansion coefficients of the second plurality of electrical interconnects and the second electrically-insulating substrate. Bowing of the second electrically-insulated substrate may be particularly well reduced in embodiments, in which the fourth pattern is similar to or substantially the same as the second pattern.

The first plurality of electrical interconnects occupies an area fraction of less than one of the first surface of the first electrically-insulating substrate. The first plurality of electrical interconnects may occupy an area fraction of up to 95%, up to 90% or up to 80% of the first surface of the first electrically-insulating substrate. The first plurality of electrical interconnects may occupy an area fraction of at least 10%, at least 20% or at least 30% of the first surface of the first electrically-insulating substrate.

The one or more regions of metallic material disposed in the third pattern on the second face of the first electrically-insulating substrate occupy an area fraction of less than one of the second surface of the first electrically-insulating substrate. The one or more regions of metallic material disposed in the third pattern on the second face of the first electrically-insulating substrate may occupy an area fraction of up to 95%, up to 90% or up to 80% of the second surface of the first electrically-insulating substrate. The one or more regions of metallic material disposed in the third pattern on the second face of the first electrically-insulating substrate may occupy an area fraction of at least 10%, at least 20% or at least 30% of the second surface of the first electrically-insulating substrate.

The second plurality of electrical interconnects occupies an area fraction of less than one of the first surface of the second electrically-insulating substrate. The second plurality of electrical interconnects may occupy an area fraction of up to 95%, up to 90% or up to 80% of the first surface of the second electrically-insulating substrate. The second plurality of electrical interconnects may occupy an area fraction of at least 10%, at least 20% or at least 30% of the second surface of the first electrically-insulating substrate.

The one or more regions of metallic material disposed in the fourth pattern on the second face of the second electrically-insulating substrate occupy an area fraction of less than one of the second surface of the second electrically-insulating substrate. The one or more regions of metallic material disposed in the fourth pattern on the second face of the second electrically-insulating substrate may occupy an area fraction of up to 95%, up to 90% or up to 80% of the second surface of the second electrically-insulating substrate. The one or more regions of metallic material disposed in the fourth pattern on the second face of the second electrically-insulating substrate may occupy an area fraction of at least 10%, at least 20% or at least 30% of the second surface of the second electrically-insulating substrate.

There exists a thermal interface between an outer surface of the thermoelectric module (i.e. the second face of the first electrically-insulating substrate or the second face of the second electrically-insulating substrate) and any system that it is mounted into. This thermal interface results in an additional interface thermal resistance, which can reduce system performance when the thermoelectric module is used as a thermoelectric generator or a heat pump. If one or more regions of metallic material is/are disposed on the second face of the first electrically-insulating substrate and/or the second face of the second electrically-insulating substrate with an area fraction less than one, then the area for this thermal interface is reduced. This reduction in the area for the thermal interface increases the interface thermal resistance, further reducing the system performance. Therefore, the reduction in warping, e.g. bowing, of the substrate(s) can come with a performance penalty.

The spaces around and/or between the regions of metallic material disposed in the third pattern on the second surface of the first electrically-insulating substrate may reduce the interface area between the thermoelectric module and the mounting plate. A thermal interface material such as a grease, paste, putty, pad or graphite sheet may be used to reduce the thermal interface resistance between the thermoelectric module and the mounting plate. A thermal interface material may be used to fill in the gaps between the regions of metallic material disposed in the third pattern on the second surface of the first electrically-insulating substrate, but thermal interface materials typically have a thermal conductivity much smaller than that of the first electrically-insulating substrate and the one or more regions of metallic material disposed in the third pattern on the second surface of the first electrically-insulating substrate.

Advantageously, parallelisation of the thermoelectric elements, using the electrical interconnects, provides improved fault tolerance. Provision of one or more regions of metallic material disposed on the second face of the first electrically-insulating substrate reduces substrate warping, e.g. bowing. This combination therefore increases module yield, lifetime and/or performance. This combination provides a further advantage, in that the interconnect requirements for parallelisation significantly increase the area fraction of the interconnects on the first face of the first electrically-insulating substrate, thus reducing the penalty of the increased interface thermal resistance from the one or more regions of metallic material disposed in the third pattern on the second face of the first electrically-insulating substrate.

Each substrate present may be made from any suitable electrically insulating, thermally conductive material or combination of materials. Examples of suitable materials may include aluminium oxide, aluminium nitride, beryllium oxide, zinc oxide, silicon oxide or silicon nitride, or any combination of such materials. The thermal expansion coefficient of any substrate present may be in the range of from 2 x 10⁻⁶ K⁻¹ to 11 x 10⁻⁶ K⁻¹.

The electrical interconnects may be made of any suitable conductive material or combination of materials, which may include metals such as silver, copper or aluminium, for example. The thermal expansion coefficient of the electrical interconnects may be in the range from 14 x 10⁻⁶ K⁻¹ to 25 x 10⁻⁶ K⁻¹.

The electrical interconnects may be formed on the first and/or second substrate by direct bonding, sintering, brazing or electroless or electrolytic plating.

The thermoelectric module may be electrically connected to an external power source to provide cooling or heating, or be thermally connected across a temperature difference between the substrates to generate electrical power, for example.

Thermoelectric elements may only be connected in parallel in the areas of largest stresses, for example edges or corners.

One or more thermoelectric elements in the thermoelectric module disposed at or near a corner may be connected in parallel to an adjacent thermoelectric element of the same type.

One or more thermoelectric elements in the thermoelectric module disposed at or near an edge may be connected in parallel to an adjacent thermoelectric element of the same type.

Additional thermal stresses occur due to the thermal gradient present on the module in operation. These thermal stresses can reduce thermoelectric module lifetime, especially in thermal cycling operation. This thermal stress is larger for larger thermoelectric modules, due to the larger difference in lateral thermal expansion. Advantageously, the stresses may be reduced by forming one or more of the substrates from a plurality of smaller substrate parts.

The thermoelectric elements may comprise any suitable thermoelectric material, for example the thermoelectric elements may comprise any one or more of: bismuth telluride; bismuth selenide; antimony telluride; lead telluride; lead selenide; magnesium silicide; magnesium stannide; magnesium antimonide, magnesium bismuthide, higher manganese silicide; skutterudite materials; Half Heusler alloys; silicon-germanium and oxides. Suitable thermoelectric materials may include any binary, tertiary or quaternary compound, or any chemical composition, of the above listed elements (or any other elements), that exhibits favourable thermoelectric properties. The thermoelectric material may be crystalline or amorphous. The thermoelectric materials may also include any suitable combination of dopants and/or other additives that may alter the chemical composition and/or thermoelectric properties.

The thermoelectric elements may be joined to the interconnects by soldering, brazing, sintering, diffusion bonding, conductive adhesives or any other suitable method.

The first substrate and/or the second substrate may have a thickness of at least 0.05 mm or at least 0.1 mm.

The first substrate and/or the second substrate may have a thickness of up to 3 mm or up to 2 mm.

For example, the first substrate and/or the second substrate may have a thickness in the range of from 0.1 mm to 2 mm or in the range of from 0.3 mm to 1 mm.

The electrical interconnects may have a thickness in the range of from 0.001 mm to 2 mm. For instance, the electrical interconnects may have a thickness in the range of from 0.01 to 0.4 mm or in the range of from 0.05 mm to 0.3 mm.

The electrical interconnects may have a thickness of at least 0.01 mm, at least 0.02 mm, at least 0.05 mm or at least 0.1 mm.

The electrical interconnects may have a thickness of up to 0.2 mm, up to 0.30 mm or up to 0.4 mm.

The thermoelectric module may be a multistage or cascade module, where a third substrate is disposed between a first substrate and a second substrate, with n-type and p-type thermoelectric elements disposed between the first and third substrate and between the second and third substrate.

The thermoelectric module may comprise one or more further series-connected strings of alternating n-type and p-type thermoelectric elements.

Each series-connected string of alternating n-type and p-type thermoelectric elements may be considered to be a string of one or more electrically-connected thermocouples. Each thermocouple includes an n-type thermoelectric element and a p-type thermoelectric element.

A further aspect provides a method of manufacturing a thermoelectric module comprising:
providing a second electrically-insulating substrate having a first face, wherein a second plurality of electrical interconnects is disposed in a second pattern on the first face of the second electrically-insulating substrate;
providing a plurality of thermoelectric elements comprising n-type thermoelectric elements and p-type thermoelectric elements;
connecting a first end of each thermoelectric element to one of the first plurality of electrical interconnects;
connecting a second end of each thermoelectric element to one of the second plurality of electrical interconnects;
wherein the thermoelectric elements are arranged to form a first series-connected string of alternating n-type and p-type thermoelectric elements and a second series-connected string of alternating n-type and p-type thermoelectric elements and at least one of the n-type or p-type thermoelectric elements in the first series-connected string is electrically connected in parallel with one of the thermoelectric elements of the same type (n-type or p-type) in the second series-connected string;
wherein at least one of the parallel connections is via one of the first plurality of interconnects.

The thermoelectric module may be a thermoelectric module according to an embodiment disclosed herein.

The method may comprise disposing, e.g. depositing, the first plurality of electrical interconnects in the first pattern on the first face of the first electrically-insulating substrate.

The method may comprise disposing, e.g. depositing, the one or more regions of metallic material in the third pattern on the second face of the first electrically-insulating substrate.

The method may comprise disposing, e.g. depositing, the second plurality of electrical interconnects in the second pattern on the first face of the second electrically-insulating substrate.

At least one pair of thermoelectric elements comprising a thermoelectric element in the first series-connected string and a thermoelectric element of the same type in the second series-connected string that are electrically connected in parallel may be disposed at or in the vicinity of a corner or corner region of the first electrically-insulating substrate and/or the second electrically-insulating substrate.

At least one pair of thermoelectric elements comprising a thermoelectric element in the first series-connected string and a thermoelectric element of the same type in the second series-connected string that are electrically connected in parallel may be disposed at or in the vicinity of a corner or corner region of the first electrically-insulating substrate and/or the second electrically-insulating substrate.

At least one pair of thermoelectric elements comprising a thermoelectric element in the first series-connected string and a thermoelectric element of the same type in the second series-connected string that are electrically connected in parallel may be disposed at or in the vicinity of an edge or edge region of the first electrically-insulating substrate and/or the second electrically-insulating substrate.

Every thermoelectric element in the first series-connected string may be electrically connected in parallel with one of the thermoelectric elements of the same type in the second series-connected string.

In an example implementation, not every thermoelectric element in the first series-connected string may be electrically connected in parallel with one of the thermoelectric elements of the same type in the second series-connected string. One or more of the thermoelectric elements in the first series-connected string may not be electrically connected in parallel with one of the thermoelectric elements of the same type in the second series-connected string.

For instance, up to 5%, up to 10%, up to 20%, up to 30%, up to 40%, up to 50%, up to 60%, up to 70%, up to 80%, up to 90% or up to 95% of the thermoelectric elements in the first series-connected string may each be electrically connected in parallel with one of the thermoelectric elements of the same type in the second series-connected string.

For instance, at least 5%, at least 10%, at least 20%, at least 30%, at least 40%, at least 50%, at least 60%, at least 70%, at least 80%, at least 90% or at least 95% of the thermoelectric elements in the first series-connected string may each be electrically connected in parallel with one of the thermoelectric elements of the same type in the second series-connected string.

Within the first series-connected string, there may be one or more regions where not every thermoelectric element is electrically connected in parallel with one of the thermoelectric elements of the same type in the second series-connected string, i.e. there may be one or more regions within the first series-connected string where one or more thermoelectric elements are not electrically connected in parallel with one of the thermoelectric elements of the same type in the second series-connected string. For example, there may be one or more regions within the first series-connected string where every second thermoelectric element, every third thermoelectric element, every fourth thermoelectric element, every fifth thermoelectric element or every sixth thermoelectric element is electrically connected in parallel with one of the thermoelectric elements of the same type in the second series-connected string.

The third pattern may be similar to or substantially the same as the first pattern.

The third pattern may have an area fraction on the second face of the first electrically-insulating substrate that is smaller than, the same as or larger than an area fraction of the first pattern on the first face of the first electrically-insulating substrate.

One or more regions of metallic material may be disposed in a fourth pattern on a second face opposite the first face of the second electrically-insulating substrate.

The fourth pattern may be similar to or substantially the same as the second pattern.

The fourth pattern may have an area fraction on the second face of the second electrically-insulating substrate that is smaller than, the same as or larger than an area fraction of the second pattern on the first face of the second electrically-insulating substrate.

The method may comprise disposing, e.g. depositing, the one or more regions of metallic material in the fourth pattern on the second face of the second electrically-insulating substrate.

At least one of the first plurality of electrical interconnects and/or at least one of the second plurality of electrical interconnects may be connected to two or more n-type thermoelectric elements and two or more p-type thermoelectric elements.

At least one of the first plurality of electrical interconnects and/or at least one of the second plurality of electrical interconnects may be rectangular, e.g. square, in shape, and connected to two n-type thermoelectric elements and two p-type thermoelectric elements with the thermoelectric elements being connected to the electrical interconnect(s) at or close to the corners of the rectangular, e.g. square, electrical interconnect(s).

The first substrate and/or the second substrate may be made up of two or more substrate parts.

The first substrate and/or the second substrate may be made up of at least two rows of substrate parts.

The first substrate and/or the second substrate may be made up of up to five rows of substrate parts.

The first substrate and/or the second substrate may be made up of at least two columns of substrate parts.

The first substrate and/or the second substrate may be made up of up to five columns of substrate parts.

The thermoelectric module may be connected to an external system by a mounting plate connected to the third pattern on the second surface of the first electrically-insulating substrate.

The mounting plate may comprise or may be a part of: an item requiring heating or cooling; a thermally conductive block; or a heat transfer device such as a heat sink or a heat exchanger.

When the first electrically-insulating substrate experiences a temperature change during operation, the presence of the one or more regions of metallic material disposed in the third pattern on the second face of the first electrically-insulating substrate may help to minimise or prevent warping, e.g. bowing, by offsetting or balancing forces on the two faces of the first electrically-insulating substrate.

When the second electrically-insulating substrate experiences a temperature change during operation, the presence of the one or more regions of metallic material disposed in the fourth pattern on the second face of the second electrically-insulating substrate may help to minimise or prevent warping, e.g. bowing, by offsetting or balancing forces on the two faces of the second electrically-insulating substrate.

The presence of the third pattern can reduce bowing of the first electrically-insulating substrate due to the different thermal expansion coefficients of the first plurality of electrical interconnects and the first electrically-insulating substrate. Bowing of the first electrically-insulating substrate may be particularly well reduced in embodiments, in which the third pattern is similar to or substantially the same as the first pattern.

The presence of the fourth pattern can reduce bowing of the second electrically-insulating substrate due to the different thermal expansion coefficients of the second plurality of electrical interconnects and the second electrically-insulating substrate. Bowing of the second electrically-insulated substrate may be particularly well reduced in embodiments, in which the fourth pattern is similar to or substantially the same as the second pattern.

The first plurality of electrical interconnects occupies an area fraction of less than one of the first surface of the first electrically-insulating substrate. The first plurality of electrical interconnects may occupy an area fraction of up to 95%, up to 90% or up to 80% of the first surface of the first electrically-insulating substrate. The first plurality of electrical interconnects may occupy an area fraction of at least 10%, at least 20% or at least 30% of the first surface of the first electrically-insulating substrate.

The one or more regions of metallic material disposed in the third pattern on the second face of the first electrically-insulating substrate occupy an area fraction of less than one of the second surface of the first electrically-insulating substrate. The one or more regions of metallic material disposed in the third pattern on the second face of the first electrically-insulating substrate may occupy an area fraction of up to 95%, up to 90% or up to 80% of the second surface of the first electrically-insulating substrate. The one or more regions of metallic material disposed in the third pattern on the second face of the first electrically-insulating substrate may occupy an area fraction of at least 10%, at least 20% or at least 30% of the second surface of the first electrically-insulating substrate.

The second plurality of electrical interconnects occupies an area fraction of less than one of the first surface of the second electrically-insulating substrate. The second plurality of electrical interconnects may occupy an area fraction of up to 95%, up to 90% or up to 80% of the first surface of the second electrically-insulating substrate. The second plurality of electrical interconnects may occupy an area fraction of at least 10%, at least 20% or at least 30% of the second surface of the first electrically-insulating substrate.

The one or more regions of metallic material disposed in the fourth pattern on the second face of the second electrically-insulating substrate occupy an area fraction of less than one of the second surface of the second electrically-insulating substrate. The one or more regions of metallic material disposed in the fourth pattern on the second face of the second electrically-insulating substrate may occupy an area fraction of up to 95%, up to 90% or up to 80% of the second surface of the second electrically-insulating substrate. The one or more regions of metallic material disposed in the fourth pattern on the second face of the second electrically-insulating substrate may occupy an area fraction of at least 10%, at least 20% or at least 30% of the second surface of the second electrically-insulating substrate.

There exists a thermal interface between an outer surface of the thermoelectric module (i.e. the second face of the first electrically-insulating substrate or the second face of the second electrically-insulating substrate) and any system that it is mounted into. This thermal interface results in an additional interface thermal resistance, which can reduce system performance when the thermoelectric module is used as a thermoelectric generator or a heat pump. If one or more regions of metallic material is/are disposed on the second face of the first electrically-insulating substrate and/or the second face of the second electrically-insulating substrate with an area fraction less than one, then the area for this thermal interface is reduced. This reduction in the area for the thermal interface increases the interface thermal resistance, further reducing the system performance. Therefore, the reduction in warping, e.g. bowing, of the substrate(s) can come with a performance penalty.

The spaces around and/or between the regions of metallic material disposed in the third pattern on the second surface of the first electrically-insulating substrate may reduce the interface area between the thermoelectric module and the mounting plate. A thermal interface material such as a grease, paste, putty, pad or graphite sheet may be used to reduce the thermal interface resistance between the thermoelectric module and the mounting plate. A thermal interface material may be used to fill in the gaps between the regions of metallic material disposed in the third pattern on the second surface of the first electrically-insulating substrate, but thermal interface materials typically have a thermal conductivity much smaller than that of the first electrically-insulating substrate and the one or more regions of metallic material disposed in the third pattern on the second surface of the first electrically-insulating substrate.

Advantageously, parallelisation of the thermoelectric elements, using the electrical interconnects, provides improved fault tolerance. Provision of one or more regions of metallic material disposed on the second face of the first electrically-insulating substrate reduces substrate warping, e.g. bowing. This combination therefore increases module yield, lifetime and/or performance. This combination provides a further advantage, in that the interconnect requirements for parallelisation significantly increase the area fraction of the interconnects on the first face of the first electrically-insulating substrate, thus reducing the penalty of the increased interface thermal resistance from the one or more regions of metallic material disposed in the third pattern on the second face of the first electrically-insulating substrate.

Each substrate present may be made from any suitable electrically insulating, thermally conductive material or combination of materials. Examples of suitable materials may include aluminium oxide, aluminium nitride, beryllium oxide, zinc oxide, silicon oxide or silicon nitride, or any combination of such materials. The thermal expansion coefficient of any substrate present may be in the range of from 2 x 10⁻⁶ K⁻¹ to 11 x 10⁻⁶ K⁻¹.

The electrical interconnects may be made of any suitable conductive material or combination of materials, which may include metals such as silver, copper or aluminium, for example. The thermal expansion coefficient of the electrical interconnects may be in the range from 14 x 10⁻⁶ K⁻¹ to 25 x 10⁻⁶ K⁻¹.

The electrical interconnects may be formed on the first and/or second substrate by direct bonding, sintering, brazing or electroless or electrolytic plating.

The thermoelectric module may be electrically connected to an external power source to provide cooling or heating, or be thermally connected across a temperature difference between the substrates to generate electrical power, for example. Thermoelectric elements may only be connected in parallel in the areas of largest stresses, for example edges or corners.

One or more thermoelectric elements in the thermoelectric module disposed at or near a corner may be connected in parallel to an adjacent thermoelectric element of the same type.

One or more thermoelectric elements in the thermoelectric module disposed at or near an edge may be connected in parallel to an adjacent thermoelectric element of the same type.

Additional thermal stresses occur due to the thermal gradient present on the module in operation. These thermal stresses can reduce thermoelectric module lifetime, especially in thermal cycling operation. This thermal stress is larger for larger thermoelectric modules, due to the larger difference in lateral thermal expansion. Advantageously, the stresses may be reduced by forming one or more of the substrates from a plurality of smaller substrate parts.

The thermoelectric elements may comprise any suitable thermoelectric material, for example the thermoelectric elements may comprise any one or more of: bismuth telluride; bismuth selenide; antimony telluride; lead telluride; lead selenide; magnesium silicide; magnesium stannide; magnesium antimonide, magnesium bismuthide, higher manganese silicide; skutterudite materials; Half Heusler alloys; silicon-germanium and oxides. Suitable thermoelectric materials may include any binary, tertiary or quaternary compound, or any chemical composition, of the above listed elements (or any other elements), that exhibits favourable thermoelectric properties. The thermoelectric material may be crystalline or amorphous. The thermoelectric materials may also include any suitable combination of dopants and/or other additives that may alter the chemical composition and/or thermoelectric properties.

The thermoelectric elements may be joined to the interconnects by soldering, brazing, sintering, diffusion bonding, conductive adhesives or any other suitable method.

The first substrate and/or the second substrate may have a thickness of at least 0.05 mm or at least 0.1 mm.

The first substrate and/or the second substrate may have a thickness of up to 3 mm or up to 2 mm.

For example, the first substrate and/or the second substrate may have a thickness in the range of from 0.1 mm to 2 mm or in the range of from 0.3 mm to 1 mm.

The electrical interconnects may have a thickness in the range of from 0.001 mm to 2 mm. For instance, the electrical interconnects may have a thickness in the range of from 0.01 to 0.4 mm or in the range of from 0.05 mm to 0.3 mm.

The electrical interconnects may have a thickness of at least 0.01 mm, at least 0.02 mm, at least 0.05 mm or at least 0.1 mm.

The electrical interconnects may have a thickness of up to 0.2 mm, up to 0.30 mm or up to 0.4 mm.

The thermoelectric module may be a multistage or cascade module, where a third substrate is disposed between a first substrate and a second substrate, with n-type and p-type thermoelectric elements disposed between the first and third substrate and between the second and third substrate.

The thermoelectric module may comprise one or more further series-connected strings of alternating n-type and p-type thermoelectric elements.

Each series-connected string of alternating n-type and p-type thermoelectric elements may be considered to be a string of one or more electrically-connected thermocouples.

Each thermocouple includes an n-type thermoelectric element and a p-type thermoelectric element.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

Embodiments will now be described, by way of example only, with reference to the accompanying drawings, in which:
Figure 1 is a schematic representation of a standard thermoelectric module;
Figure 2 is a plan and side view of a first substrate and electrical interconnect pattern in a standard thermoelectric module;
Figure 3 is a side view of a first substrate and electrical interconnect pattern in a standard thermoelectric module exhibiting bowing after a temperature change;
Figure 4 is a plan and side view of a first substrate with an electrical interconnect pattern on a first face of the first substrate and a plurality of regions of metallic material disposed in a pattern on a second face opposite the first face of the first substrate;
Figure 5 is a side view of the arrangement of Figure 4 after a temperature change;
Figure 6 is a side view of a thermoelectric module with an electrical interconnect pattern on a first face of the first substrate and a plurality of regions of metallic material disposed in a pattern on a second face opposite the first face of the first substrate when interfaced with a mounting plate;
Figure 7 is a plan view of a first substrate, electrical interconnects and thermoelectric elements in a standard thermoelectric module;
Figure 8A is a schematic of the electrical connections of a standard thermoelectric module;
Figure 8B is a schematic of the electrical connections of a thermoelectric module according to an embodiment;
Figure 8C is a schematic of the electrical connections of a thermoelectric module as shown in 8B after a failure has occurred;
Figure 9 is a plan and side view of a thermoelectric module according to an embodiment; and
Figure 10 is a plan view of the first and second substrates according to an embodiment.

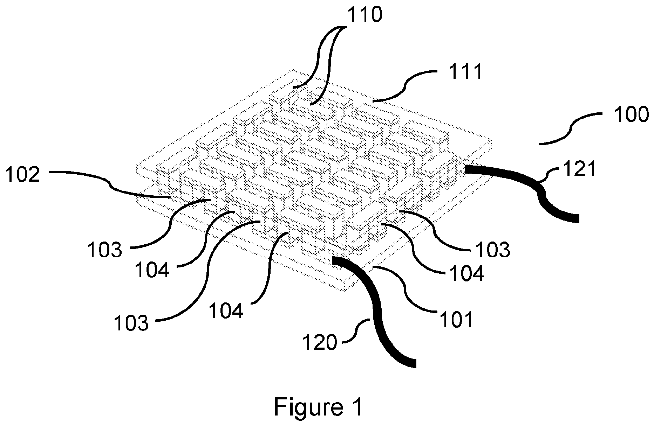

An example of a standard thermoelectric module 100 as is known in the art is shown in Figure 1. The thermoelectric module 100 comprises a first electrically-insulating substrate 101 and a first plurality of electrical interconnects 102 disposed on a first face of the first substrate 101. A second plurality of electrical interconnects 110 is disposed on a first face of a second electrically-insulating substrate 111. The second substrate 111 is shown as transparent for clarity. The electrical interconnects 102, 110 connect alternating n-type thermoelectric elements 104 and p-type thermoelectric elements 103 in series, thereby forming a string of electrically-connected thermocouples. External wires 120, 121 allow external electrical connection. Such a thermoelectric module 100 may be electrically connected to an external power source (not shown) to provide electrical cooling or heating, or be thermally connected across a temperature difference between the substrates 101, 111 to generate electrical power.

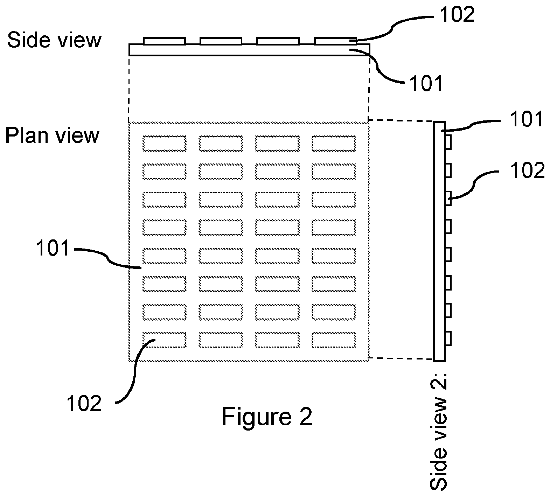

Figure 2 shows a plan and two side views of the first electrically-insulating substrate 101 and the first plurality of electrical interconnects 102 disposed on the first face of the first substrate 101.

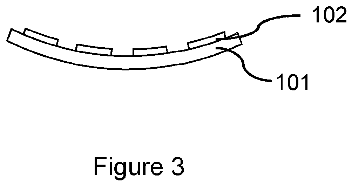

Figure 3 shows an example of the warping that can occur when the first substrate 101 and the first plurality of electrical interconnects 102 disposed thereon are subject to a temperature change resulting in a warped first substrate and warped electrical interconnects thereon. The example here is geometrically exaggerated for clarity, and shows an example of the warping when a temperature reduction from the bonding temperature of the first plurality of electrical interconnects 102 and the first substrate 101 occurs, where the thermal expansion coefficient of the first plurality of electrical interconnects 102 is higher than the thermal expansion coefficient of the first substrate 101.

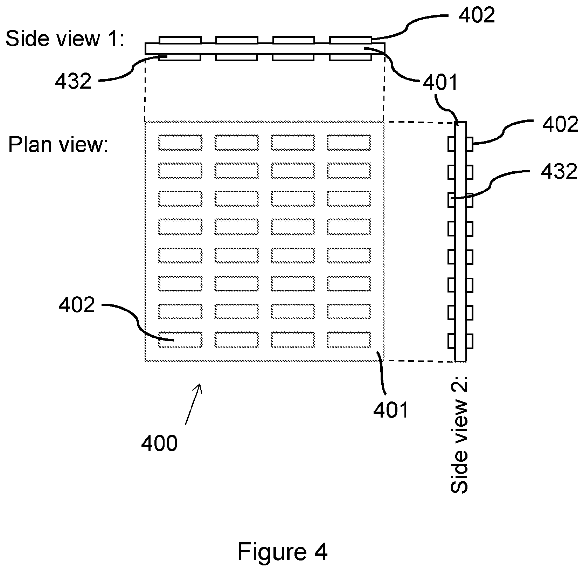

Figure 4 shows a portion of a thermoelectric module 400, specifically a first electrically-insulating substrate 401 with a first plurality of electrical interconnects 402 disposed in a pattern on a first surface of the first electrically-insulating substrate 401. A plurality of regions of metallic material 432 is disposed in a pattern on a second surface of the first electrically-insulating substrate 401. The second surface of the first electrically-insulating substrate 401 is opposite the first surface of the first electrically-insulating substrate 401. The first plurality of electrical interconnects 402 are joined to thermoelectric elements in a subsequent module assembly operation.

In some embodiments, the patterns on the first and second faces of the first substrate may be substantially similar or identical.

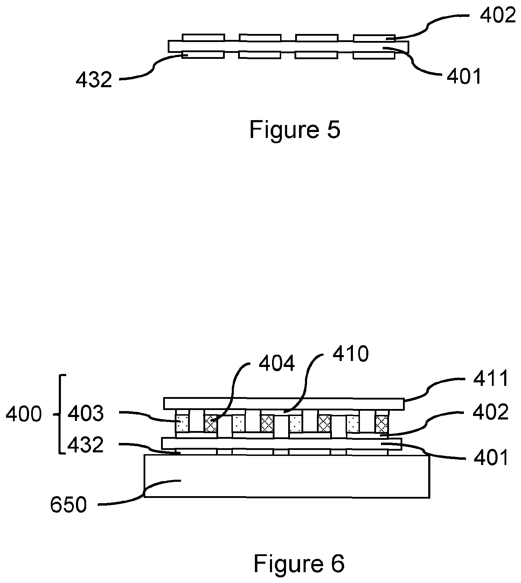

Figure 5 shows the resulting geometry change to the first substrate 401, the first plurality of electrical interconnects 402 and the regions of metallic material 432 when a temperature change is applied thereto.. It can be seen that the use of substantially identical patterns on both faces of the substrate 401 drastically reduces the warping, due to the balance forces from the two patterns. Note that the first substrate 401, and the first plurality of electrical interconnects 402 and the regions of metallic material 432 will still change in length, width and height due to thermal expansion or contraction, but the warping, which may be of larger scale, is reduced or even avoided.

The patterns on both faces of the first substrate may differ in size, shape and the area fraction of the substrate. The larger the difference in area fraction of the substrate covered by the two patterns, the less the warping will be reduced from only having the first pattern (i.e. the pattern formed by the first plurality of electrical interconnects).

Figure 6 shows a side view of the thermoelectric module 400 comprising the first electrically-insulating substrate 401 with the first plurality of electrical interconnects 402 disposed in a first pattern on the first face of the first electrically-insulating substrate 401 and the regions of metallic material 432 disposed in a third pattern on the second face of the first electrically-insulating substrate 401. A second plurality of electrical interconnects 410 is disposed in a second pattern on a first face of a second electrically-insulating substrate 411. Alternating n-type thermoelectric elements 404 and p-type thermoelectric elements 403 are disposed between the first electrically-insulating substrate 401 and the second electrically-insulating substrate 411. The electrical interconnects 402, 410 connect the n-type thermoelectric elements 404 and the p-type thermoelectric elements 403 in series, thereby forming a string of electrically connected thermocouples. The thermoelectric module 400 is mounted to an external system by a mounting plate 650 connected to the regions of metallic material 432 disposed on the second face of the first electrically-insulating substrate. The mounting plate 650 may comprise or be part of: an item requiring heating or cooling; a thermally conductive block; or a heat transfer device such as a heat sink or a heat exchanger. It can be seen that the use of the regions of metallic material 432 reduces the interface area between the thermoelectric module 400 and the mounting plate 650. This reduction in area increases the thermal resistance of this interface. This can result in a reduction in performance of the thermoelectric module, providing a barrier to heat flow for a thermoelectric heat pump and reducing the temperature difference across the module for a thermoelectric generator.

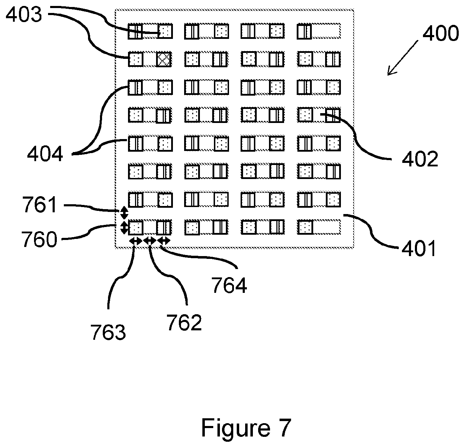

Figure 7 shows a plan view of part of the thermoelectric module 400, showing the first electrically-insulating substrate 401, the first plurality of electrical interconnects 402 disposed on the first face of the first electrically-insulating substrate 401 and alternating n-type thermoelectric elements 404 and p-type thermoelectric elements 403. The length, *l* of the thermoelectric elements is shown as 760, with a width of the n-type thermoelectric element defined as *wn*, 764 and the width of the p-type thermoelectric element defined as *wp*, 763. The spacing between the thermoelectric elements is defined as *sv* 761 in one direction and *sh* 762 in the other direction. For the purpose of this example it is assumed that the electrical interconnects line up with the relevant edges of the thermoelectric elements. The fraction of substrate area covered by the interconnects, *AF* is then given by: $AF = \frac{l \times \left(wp+sh+wn\right)}{\left(l+sv\right) \times \left(wp+2sh+wn\right)}$

Using the common simplification, *sv = sh = s, wp = wn* = *l* = *w* $AF = \frac{w \times \left(2w+s\right)}{\left(w+s\right) \times \left(2w+2s\right)} \leq 1$

It can be seen that increasing *w* and decreasing s results in a higher *AF,* but this results in changes in thermoelectric performance and often cost increases due to more thermoelectric material usage, and *s* typically has a lower limit imposed by manufacturing constraints. Therefore, it is not easy to avoid the extra interface thermal resistance between the thermoelectric module and the mounting plate due to the reduced interface area.

In some embodiments, a thermal interface material such as a grease, paste, putty, pad or graphite sheet may be used to reduce the thermal interface resistance between the thermoelectric module and the mounting plate. A thermal interface material may be used to fill in the gaps between the second electrical interconnects. Thermal interface materials typically may have a thermal conductivity much smaller than that of the substrate and electrical interconnects.

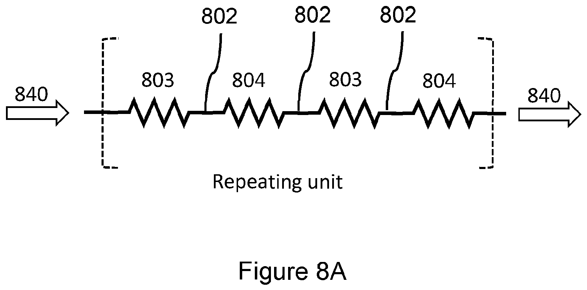

Figure 8A shows a repeating unit of the typical electrical connections in a thermoelectric module, with the alternating n-type thermoelectric elements' resistance 804 and p-type thermoelectric elements' resistance 803. These are joined by the electrical interconnects 802, allowing current flow 840 to occur along the series-connected string. The series-connected string of the thermoelectric elements means that any break in a thermoelectric element, electrical interconnect or joint between them breaks the electrical circuit, leading to complete module failure as there is no continuous path for the current to flow.

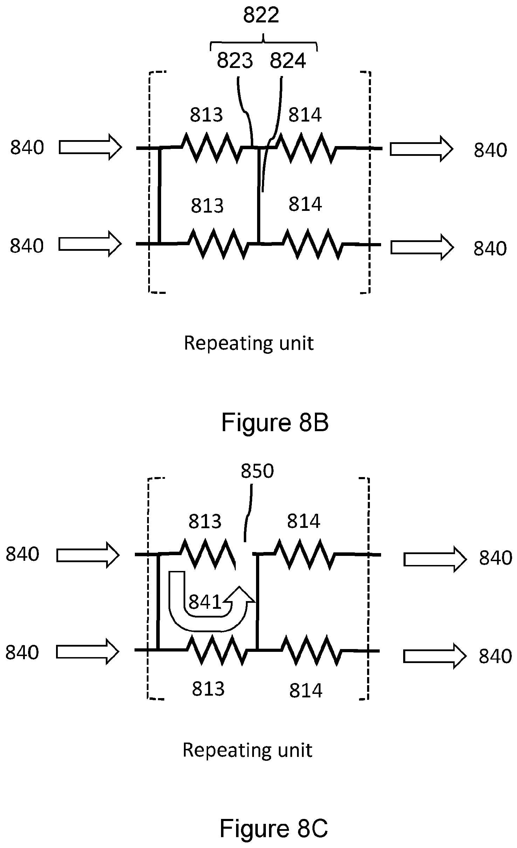

Figure 8B shows a repeating unit of the electrical connections in a thermoelectric module according to an embodiment, where the n-type thermoelectric elements' resistance 814 and p-type thermoelectric elements' resistance 813 is connected by an electrical interconnect 822. The electrical interconnect 822 connects n and p-type thermoelectric elements in a series-connected string using a first interconnect portion 823, and provides a cross connection to a second series-connected string through a second interconnect portion 824. The current flow in normal operation is shown by 840, with minimal current flow through the cross connection provided by the second interconnect portion 824. In some implementations, the use of two series-connected strings with multiple cross-connections between them may mean that every thermoelectric element of a given type (n-type or p-type) is in parallel with another thermoelectric element of the same type. If any single break in a thermoelectric element, electrical interconnect or joint between them occurs, there is an alternative electrical path around the break. An example is illustrated in Figure 8C, where a break in the thermoelectric module, depicted by 850, disrupts the current flow from one thermoelectric element to the electrical interconnect. The use of cross connections between the series-connected strings, putting thermoelectric elements in parallel, means that there is an alternative current path, 841. This avoids complete module failure, as current can continue to flow with only a small drop in module performance.

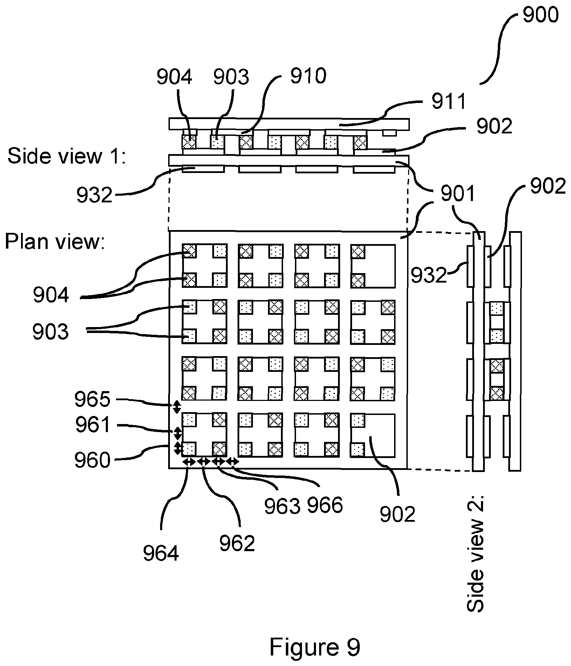

Figure 9 shows a plan and side view of a thermoelectric module 900. The thermoelectric module 900 comprises a first electrically-insulating substrate 901, a first plurality of electrical interconnects 902 disposed in a first pattern on a first face (the inner face) of the first substrate 901 and regions of metallic material 932 disposed in a third pattern on a second face (the outer face) of the first substrate 901. A second plurality of electrical interconnects 910 is disposed in a second pattern on a first face (the inner face) of a second electrically-insulating substrate 911. The electrical interconnects 902, 910 connect n-type thermoelectric elements 904 and p-type thermoelectric elements 903 in two series-connected strings, with each series-connected string cross-connected to each other, so that every thermoelectric element is electrically in parallel to an adjacent thermoelectric element of the same type. Such a thermoelectric module may be electrically connected to an external power source to provide electrical cooling or heating, or be thermally connected across a temperature difference between the substrates 901, 911 to generate electrical power.

The length, *l* of the thermoelectric elements is shown as 960, with a width of the n-type thermoelectric element defined as *wn,* 964 and the width of the p-type thermoelectric element defined as *wp*, 963. The spacing between thermoelectric elements on the same interconnect is defined as *ssv* 961 in one direction and *ssh* 962 in the other direction. The spacing between thermoelectric elements on different interconnects is defined as *sdv* 965 in one direction and *sdh* 966 in the other direction. For the purpose of this example it is assumed that the interconnects match to the relevant edges of the thermoelectric elements. The fraction of area covered by the interconnect when using parallelisation, *AFP* is then given by: $AFP = \frac{\left(2l+ssv\right) \times \left(wp+ssh+wn\right)}{\left(2l+ssv+sdv\right) \times \left(wp+ssh+wn+sdh\right)}$

Using the common simplification, *ssv* = *ssh* = *sdv* = *sdh = s, wp = wn = l* = *w* $AFP = \frac{{\left(2w+s\right)}^{2}}{{\left(2w+2s\right)}^{2}} \leq 1$

Comparing this area fraction to the case without parallelisation of the TE elements: $\frac{AFP}{AF} = \frac{\left(2w+s\right) \left(w+s\right)}{\left(2w+2s\right) \left(w\right)} = \frac{2 {w}^{2} + 3 ws + {s}^{2}}{2 {w}^{2} + 2 ws} > 1$

This shows that for any positive value of s and w, introducing parallelisation leads to a larger fraction of the area of the first substrate being covered by the first plurality of interconnects. Therefore, with a substantially similar third pattern of regions of metallic material disposed on the second face of the first electrically-insulating substrate, there would be a similar larger area fraction on the second face (the outer face) of the first substrate. This larger area fraction will result in a better thermal contact, giving a lower interface thermal resistance to the mounting plate. Therefore, an advantage of this embodiment is that a first pattern is used to connect thermoelectric elements in parallel, increasing fault tolerance, and the third pattern on the other face of the first substrate is used to minimise warping, with the best results if the first and third patterns are substantially similar on each face, with the requirements on the first pattern for parallelisation increasing the area fraction of the substrate covered by the interconnect, thus reducing the performance loss due the increased thermal interface resistance caused by an area fraction that is less than one.

In some embodiments, the third pattern on the second face (the outer face) of the first substrate may be substantially similar to the first pattern on the first face (the inner face) of the first substrate.

The third pattern may cover a larger area fraction of the substrate than the first pattern. This trades some increased bowing of the first substrate for a lower thermal resistance when connecting the module to an external system by a mounting plate.

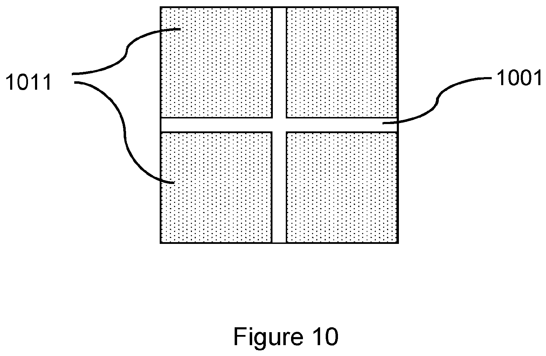

Figure 10 illustrates an embodiment where the first substrate 1001 is a single substrate, but the second substrate has been split into four substrate parts 1011. In other embodiments, more or fewer than four part substrates are provided.

## Claims

1. A thermoelectric module (900), comprising:
a first electrically-insulating substrate (901) having a first face and a second face opposite the first face, wherein a first plurality of electrical interconnects (902) is disposed in a first pattern on the first face;
a second electrically-insulating substrate (911) spaced from the first electrically-insulating substrate (901) and having a first face facing the first face of the first electrically-insulating substrate (901), wherein a second plurality of electrical interconnects (910) is disposed in a second pattern on the first face of the second electrically-insulating substrate (911);
a plurality of thermoelectric elements comprising n-type thermoelectric elements (904) and p-type thermoelectric elements (903) disposed between the first electrically-insulating substrate (901) and the second electrically-insulating substrate (911), wherein each thermoelectric element extends from one of the first plurality of electrical interconnects (902) to one of the second plurality of electrical interconnects (910), wherein the thermoelectric elements are arranged to form a first series-connected string of alternating n-type and p-type thermoelectric elements and a second series-connected string of alternating n-type and p-type thermoelectric elements and at least one of the n-type or p-type thermoelectric elements in the first series-connected string is electrically connected in parallel with one of the thermoelectric elements of the same type (n-type or p-type) in the second series-connected string; and
one or more regions of metallic material are disposed in a third pattern on the second face of the first electrically-insulating substrate (901);
wherein at least one of the parallel connections is via one of the first plurality of interconnects.

2. A thermoelectric module (900) according to claim 1, wherein at least one pair of thermoelectric elements comprising a thermoelectric element in the first series-connected string and a thermoelectric element of the same type in the second series-connected string that are electrically connected in parallel is disposed at or in the vicinity of a corner or corner region of the first electrically-insulating substrate (901) and/or the second electrically-insulating substrate (911).

3. A thermoelectric module (900) according to claim 1 or claim 2, wherein at least one pair of thermoelectric elements comprising a thermoelectric element in the first series- connected string and a thermoelectric element of the same type in the second series-connected string that are electrically connected in parallel is disposed at or in the vicinity of an edge or edge region of the first electrically-insulating substrate (901) and/or the second electrically-insulating substrate (911).

4. A thermoelectric module (900) according to claim 1, claim 2 or claim 3, wherein every thermoelectric element in the first series-connected string is electrically connected in parallel with one of the thermoelectric elements of the same type in the second series-connected string.

5. A thermoelectric module (900) according to claim 1, claim 2 or claim 3, wherein one or more of the thermoelectric elements in the first series-connected string is not electrically connected in parallel with one of the thermoelectric elements of the same type in the second series-connected string.

6. A thermoelectric module (900) according to claim 1, claim 2, claim 3, or claim 5, wherein within the first series-connected string there are one or more regions where not every thermoelectric element is connected in parallel with one of the thermoelectric elements of the same type in the second series-connected string.

7. A thermoelectric module (900) according to any one of the preceding claims, wherein the third pattern is similar to or the same as the first pattern.

8. A thermoelectric module (900) according to any one of the preceding claims, wherein one or more regions of metallic material are disposed in a fourth pattern on a second face opposite the first face of the second electrically-insulating substrate (911).

9. A thermoelectric module (900) according to claim 8, wherein the fourth pattern is similar to or the same as the second pattern.

10. A thermoelectric module (900) according to any one of the preceding claims, wherein at least one of the first plurality of electrical interconnects (902) and/or at least one of the second plurality of electrical interconnects (910) is connected to two or more n-type thermoelectric elements (904) and two or more p-type thermoelectric elements (903).

11. A thermoelectric module (900) according to claim 10, wherein at least one of the first plurality of electrical interconnects (902) and/or at least one of the second plurality of electrical interconnects (910) is/are rectangular, e.g. square, in shape, and connected to two n-type thermoelectric elements (904) and two p-type thermoelectric elements (903) with the thermoelectric elements being connected to the electrical interconnect(s) at or close to the corners of the rectangular, e.g. square, electrical interconnect(s).

12. A thermoelectric module (900) according to any one of the preceding claims, wherein the first substrate (901) and/or the second substrate (911) is/are made up of two or more substrate parts.

13. A thermoelectric module according to claim 12, wherein at least one of the following options (a), (b), (c) or (d) applies:
(a) the first substrate and/or the second substrate is/are made up of at least two rows of substrate parts;
(b) the first substrate and/or the second substrate is/are made up of up to five rows of substrate parts;
(c) the first substrate and/or the second substrate is/are made up of at least two columns of substrate parts; and/or
(d) the first substrate and/or the second substrate is/are made up of up to five columns of substrate parts.

14. A thermoelectric module (900) according to any one of the preceding claims connected to an external system by a mounting plate connected to the third pattern on the second surface of the first electrically-insulating substrate (901), optionally wherein the mounting plate comprises or is a part of: an item requiring heating or cooling; a thermally conductive block; or a heat transfer device such as a heat sink or a heat exchanger.

15. A method of manufacturing a thermoelectric module (900) comprising:
providing a first electrically-insulating substrate (901) having a first face and a second face opposite the first face, wherein a first plurality of electrical interconnects (902) is disposed in a first pattern on the first face and one or more regions of metallic material are disposed in a third pattern on the second face of the first electrically-insulating substrate (901);
providing a second electrically-insulating substrate (911) having a first face, wherein a second plurality of electrical interconnects (910) is disposed in a second pattern on the first face of the second electrically-insulating substrate (911);
providing a plurality of thermoelectric elements comprising n-type thermoelectric elements (904) and p-type thermoelectric elements (903);
connecting a first end of each thermoelectric element to one of the first plurality of electrical interconnects (902);
connecting a second end of each thermoelectric element to one of the second plurality of electrical interconnects (910);
wherein the thermoelectric elements are arranged to form a first series-connected string of alternating n-type and p-type thermoelectric elements and a second series-connected string of alternating n-type and p-type thermoelectric elements and at least one of the n-type or p-type thermoelectric elements in the first series-connected string is electrically connected in parallel with one of the thermoelectric elements of the same type (n-type or p-type) in the second series-connected string;
wherein at least one of the parallel connections is via one of the first plurality of interconnects.

## Patentansprüche

1. Thermoelektrisches Modul (900), umfassend:
ein erstes elektrisch isolierendes Substrat (901), das eine erste Fläche und eine zweite Fläche gegenüber der ersten Fläche aufweist, wobei eine erste Vielzahl von elektrischen Verbindungsleitungen (902) in einem ersten Muster auf der ersten Fläche angeordnet ist;
ein zweites elektrisch isolierendes Substrat (911), das von dem ersten elektrisch isolierenden Substrat (901) beabstandet ist und eine erste Fläche aufweist, die der ersten Fläche des ersten elektrisch isolierenden Substrats (901) zugewandt ist, wobei eine zweite Vielzahl von elektrischen Verbindungsleitungen (910) in einem zweiten Muster auf der ersten Fläche des zweiten elektrisch isolierenden Substrats (911) angeordnet ist;
eine Vielzahl von thermoelektrischen Elementen, die thermoelektrische Elemente (904) vom Typ n und thermoelektrische Elemente (903) vom Typ p umfassen, die zwischen dem ersten elektrisch isolierenden Substrat (901) und dem zweiten elektrisch isolierenden Substrat (911) angeordnet sind, wobei sich jedes thermoelektrische Element von einer der ersten Vielzahl von elektrischen Verbindungsleitungen (902) zu einer der zweiten Vielzahl von elektrischen Verbindungsleitungen (910) erstreckt, wobei die thermoelektrischen Elemente dazu angeordnet sind, eine erste in Reihe geschaltete Kette von abwechselnden thermoelektrischen Elementen vom Typ n und vom Typ p und eine zweite in Reihe geschaltete Kette von abwechselnden thermoelektrischen Elementen vom Typ n und vom Typ p zu bilden, und mindestens eines der thermoelektrischen Elemente vom Typ n oder vom Typ p in der ersten in Reihe geschalteten Kette mit einem der thermoelektrischen Elemente des gleichen Typs (vom Typ n oder vom Typ p) in der zweiten in Reihe geschalteten Kette elektrisch parallel geschaltet ist; und
ein oder mehrere Bereiche aus metallischem Material in einem dritten Muster auf der zweiten Fläche des ersten elektrisch isolierenden Substrats (901) angeordnet sind;
wobei mindestens eine der Parallelschaltungen über eine der ersten Vielzahl von Verbindungsleitungen erfolgt.

2. Thermoelektrisches Modul (900) nach Anspruch 1, wobei mindestens ein Paar thermoelektrischer Elemente, die ein thermoelektrisches Element in der ersten in Reihe geschalteten Kette und ein thermoelektrisches Element des gleichen Typs in der zweiten in Reihe geschalteten Kette, die elektrisch parallel geschaltet sind, umfassen, an oder in der Nähe einer Ecke oder eines Eckbereichs des ersten elektrisch isolierenden Substrats (901) und/oder des zweiten elektrisch isolierenden Substrats (911) angeordnet ist.

3. Thermoelektrisches Modul (900) nach Anspruch 1 oder Anspruch 2, wobei mindestens ein Paar thermoelektrischer Elemente, die ein thermoelektrisches Element in der ersten in Reihe geschalteten Kette und ein thermoelektrisches Element des gleichen Typs in der zweiten in Reihe geschalteten Kette, die elektrisch parallel geschaltet sind, umfassen, an oder in der Nähe einer Kante oder eines Kantenbereichs des ersten elektrisch isolierenden Substrats (901) und/oder des zweiten elektrisch isolierenden Substrats (911) angeordnet ist.

4. Thermoelektrisches Modul (900) nach Anspruch 1, Anspruch 2 oder Anspruch 3, wobei jedes thermoelektrische Element in der ersten in Reihe geschalteten Kette mit einem der thermoelektrischen Elemente des gleichen Typs in der zweiten in Reihe geschalteten Kette elektrisch parallel geschaltet ist.

5. Thermoelektrisches Modul (900) nach Anspruch 1, Anspruch 2 oder Anspruch 3, wobei ein oder mehrere thermoelektrische Elemente in der ersten in Reihe geschalteten Kette nicht mit einem der thermoelektrischen Elemente des gleichen Typs in der zweiten in Reihe geschalteten Kette elektrisch parallel geschaltet ist.

6. Thermoelektrisches Modul (900) nach Anspruch 1, Anspruch 2, Anspruch 3 oder Anspruch 5, wobei innerhalb der ersten in Reihe geschalteten Kette ein oder mehrere Bereiche vorhanden sind, in denen nicht jedes thermoelektrische Element mit einem der thermoelektrischen Elemente des gleichen Typs in der zweiten in Reihe geschalteten Kette parallel geschaltet ist.

7. Thermoelektrisches Modul (900) nach einem der vorhergehenden Ansprüche, wobei das dritte Muster dem ersten Muster ähnlich oder gleich ist.

8. Thermoelektrisches Modul (900) nach einem der vorhergehenden Ansprüche, wobei der eine oder die mehreren Bereiche aus metallischem Material in einem vierten Muster auf einer zweiten Fläche gegenüber der ersten Fläche des zweiten elektrisch isolierenden Substrats (911) angeordnet sind.

9. Thermoelektrisches Modul (900) nach Anspruch 8, wobei das vierte Muster dem zweiten Muster ähnlich oder gleich ist.

10. Thermoelektrisches Modul (900) nach einem der vorhergehenden Ansprüche, wobei mindestens eine der ersten Vielzahl von elektrischen Verbindungsleitungen (902) und/oder mindestens eine der zweiten Vielzahl von elektrischen Verbindungsleitungen (910) mit zwei oder mehreren thermoelektrischen Elementen (904) vom Typ n und zwei oder mehreren thermoelektrischen Elementen (903) vom Typ p verbunden ist.

11. Thermoelektrisches Modul (900) nach Anspruch 10, wobei mindestens eine der ersten Vielzahl von elektrischen Verbindungsleitungen (902) und/oder mindestens eine der zweiten Vielzahl von elektrischen Verbindungsleitungen (910) rechteckiger, z. B. quadratischer, Form ist/sind und mit zwei thermoelektrischen Elementen (904) vom Typ n und zwei thermoelektrischen Elementen (903) vom Typ p verbunden ist/sind, wobei die thermoelektrischen Elemente an oder in der Nähe der Ecken der rechteckigen, z. B., quadratischen, elektrischen Verbindungsleitung(en) mit der/den elektrischen Verbindungsleitung(en) verbunden sind.

12. Thermoelektrisches Modul (900) nach einem der vorhergehenden Ansprüche, wobei das erste Substrat (901) und/oder das zweite Substrat (911) aus zwei oder mehr Substratteilen besteht/bestehen.

13. Thermoelektrisches Modul nach Anspruch 12, wobei mindestens eine der folgenden Optionen (a), (b), (c) oder (d) gilt:
(a) das erste Substrat und/oder das zweite Substrat besteht/bestehen aus mindestens zwei Reihen von Substratteilen;
(b) das erste Substrat und/oder das zweite Substrat besteht/bestehen aus bis zu fünf Reihen von Substratteilen;
(c) das erste Substrat und/oder das zweite Substrat besteht/bestehen aus mindestens zwei Spalten von Substratteilen; und/oder
(d) das erste Substrat und/oder das zweite Substrat besteht/bestehen aus bis zu fünf Spalten von Substratteilen.

14. Thermoelektrisches Modul (900) nach einem der vorhergehenden Ansprüche, das durch eine Montageplatte, die mit dem dritten Muster auf der zweiten Oberfläche des ersten elektrisch isolierenden Substrats (901) verbunden ist, mit einem externen System verbunden ist, wobei die Montageplatte optional Folgendes umfasst oder ein Teil von Folgendem ist: ein(em) Element, das Erwärmen oder Kühlen erfordert; einen/einem wärmeleitfähigen Block; oder eine(r) Wärmeübertragungsvorrichtung, wie etwa einen/einem Wärmeableiter oder einen/einem Wärmetauscher.

15. Verfahren zum Herstellen eines thermoelektrischen Moduls (900), umfassend:
Bereitstellen eines ersten elektrisch isolierenden Substrats (901), das eine erste Fläche und eine zweite Fläche gegenüber der ersten Fläche aufweist, wobei eine erste Vielzahl von elektrischen Verbindungsleitungen (902) in einem ersten Muster auf der ersten Fläche angeordnet ist und ein oder mehrere Bereiche aus metallischem Material in einem dritten Muster auf der zweiten Fläche des ersten elektrisch isolierenden Substrats (901) angeordnet sind;
Bereitstellen eines zweiten elektrisch isolierenden Substrats (911), das eine erste Fläche aufweist, wobei eine zweite Vielzahl von elektrischen Verbindungsleitungen (910) in einem zweiten Muster auf der ersten Fläche des zweiten elektrisch isolierenden Substrats (911) angeordnet ist;
Bereitstellen einer Vielzahl von thermoelektrischen Elementen, die thermoelektrische Elemente (904) vom Typ n und thermoelektrische Elemente (903) vom Typ p umfassen;
Verbinden eines ersten Endes jedes thermoelektrischen Elements mit einer der ersten Vielzahl von elektrischen Verbindungsleitungen (902);
Verbinden eines zweiten Endes jedes thermoelektrischen Elements mit einer der zweiten Vielzahl von elektrischen Verbindungsleitungen (910);
wobei die thermoelektrischen Elemente dazu angeordnet sind, eine erste in Reihe geschaltete Kette von abwechselnden thermoelektrischen Elementen vom Typ n und vom Typ p und eine zweite in Reihe geschaltete Kette von abwechselnden thermoelektrischen Elementen vom Typ n und vom Typ p zu bilden, und mindestens eines der thermoelektrischen Elemente vom Typ n oder vom Typ p in der ersten in Reihe geschalteten Kette mit einem der thermoelektrischen Elemente des gleichen Typs (vom Typ n oder vom Typ p) in der zweiten in Reihe geschalteten Kette elektrisch parallel geschaltet ist;
wobei mindestens eine der Parallelschaltungen über eine der ersten Vielzahl von Verbindungsleitungen erfolgt.

## Revendications

1. Module thermoélectrique (900), comprenant :
un premier substrat électriquement isolant (901) présentant une première face et une seconde face opposée à la première face, dans lequel une première pluralité d'interconnexions électriques (902) est disposée selon un premier motif sur la première face ;
un second substrat électriquement isolant (911) maintenu à distance du premier substrat électriquement isolant (901) et présentant une première face tournée vers la première face dudit premier substrat électriquement isolant (901), dans lequel une seconde pluralité d'interconnexions électriques (910) est disposée selon un second motif sur la première face du second substrat électriquement isolant (911) ;
une pluralité d'éléments thermoélectriques comprenant des éléments thermoélectriques de type n (904) et des éléments thermoélectriques de type p (903) disposés entre le premier substrat électriquement isolant (901) et le second substrat électriquement isolant (911), dans lequel chaque élément thermoélectrique s'étend depuis une interconnexion de la première pluralité d'interconnexions électriques (902) jusqu'à une interconnexion de la seconde pluralité d'interconnexions électriques (910), dans lequel les éléments thermoélectriques sont agencés pour former une première chaîne connectée en série d'éléments thermoélectriques de type n et de type p alternés et une seconde chaîne connectée en série d'éléments thermoélectriques de type n et de type p alternés, et au moins un élément thermoélectrique de type n ou de type p de la première chaîne connectée en série est connecté électriquement en parallèle avec l'un des éléments thermoélectriques du même type (type n ou type p) de la seconde chaîne connectée en série ; et
au moins une région de matériau métallique est disposée selon un troisième motif sur la seconde face du premier substrat électriquement isolant (901) ;
dans lequel au moins l'une des connexions en parallèle se fait par l'intermédiaire de l'une de la première pluralité d'interconnexions.

2. Module thermoélectrique (900) selon la revendication 1, dans lequel au moins une paire d'éléments thermoélectriques, comprenant un élément thermoélectrique de la première chaîne connectée en série et un élément thermoélectrique du même type de la seconde chaîne connectée en série qui sont connectés électriquement en parallèle, est disposée au niveau ou à proximité d'un coin ou d'une région de coin du premier substrat électriquement isolant (901) et/ou du second substrat électriquement isolant (911).

3. Module thermoélectrique (900) selon la revendication 1 ou la revendication 2, dans lequel au moins une paire d'éléments thermoélectriques, comprenant un élément thermoélectrique de la première chaîne connectée en série et un élément thermoélectrique du même type de la seconde chaîne connectée en série qui sont connectés électriquement en parallèle, est disposée au niveau ou à proximité d'un bord ou d'une région de bord du premier substrat électriquement isolant (901) et/ou du second substrat électriquement isolant (911).

4. Module thermoélectrique (900) selon la revendication 1, la revendication 2 ou la revendication 3, dans lequel chaque élément thermoélectrique de la première chaîne connectée en série est connecté électriquement en parallèle avec l'un des éléments thermoélectriques du même type de la seconde chaîne connectée en série.

5. Module thermoélectrique (900) selon la revendication 1, la revendication 2 ou la revendication 3, dans lequel au moins un élément thermoélectrique de la première chaîne connectée en série n'est pas connecté électriquement en parallèle avec un des éléments thermoélectriques du même type de la seconde chaîne connectée en série.

6. Module thermoélectrique (900) selon la revendication 1, la revendication 2, la revendication 3 ou la revendication 5, dans lequel, au sein de la première chaîne connectée en série, il existe au moins une région où les éléments thermoélectriques ne sont pas tous connectés en parallèle avec un des éléments thermoélectriques du même type de la seconde chaîne connectée en série.

7. Module thermoélectrique (900) selon l'une quelconque des revendications précédentes, dans lequel le troisième motif est similaire ou identique au premier motif.

8. Module thermoélectrique (900) selon l'une quelconque des revendications précédentes, dans lequel au moins une région de matériau métallique est disposée selon un quatrième motif sur une seconde face opposée à la première face du second substrat électriquement isolant (911).

9. Module thermoélectrique (900) selon la revendication 8, dans lequel le quatrième motif est similaire ou identique au second motif.

10. Module thermoélectrique (900) selon l'une quelconque des revendications précédentes, dans lequel au moins une interconnexion de la première pluralité d'interconnexions électriques (902) et/ou au moins une interconnexion de la seconde pluralité d'interconnexions électriques (910) est connectée à au moins deux éléments thermoélectriques de type n (904) et à au moins deux éléments thermoélectriques de type p (903).

11. Module thermoélectrique (900) selon la revendication 10, dans lequel au moins une interconnexion de la première pluralité d'interconnexions électriques (902) et/ou au moins une interconnexion de la seconde pluralité d'interconnexions électriques (910) présente une forme rectangulaire, par exemple carrée, et est connectée à deux éléments thermoélectriques de type n (904) et à deux éléments thermoélectriques de type p (903), les éléments thermoélectriques étant connectés aux interconnexions électriques au niveau ou à proximité des coins des interconnexions électriques rectangulaires, par exemple carrées.

12. Module thermoélectrique (900) selon l'une quelconque des revendications précédentes, dans lequel le premier substrat (901) et/ou le second substrat (911) sont formés d'au moins deux parties de substrat.

13. Module thermoélectrique selon la revendication 12, dans lequel au moins l'une des options (a), (b), (c) ou (d) suivantes s'applique :
(a) le premier substrat et/ou le second substrat est ou sont formés d'au moins deux rangées de parties de substrat ;
(b) le premier substrat et/ou le second substrat est ou sont formés de jusqu'à cinq rangées de parties de substrat ;
(c) le premier substrat et/ou le second substrat est ou sont formés d'au moins deux colonnes de parties de substrat ; et/ou
(d) le premier substrat et/ou le second substrat est ou sont formés de jusqu'à cinq colonnes de parties de substrat.

14. Module thermoélectrique (900) selon l'une quelconque des revendications précédentes, connecté à un système externe par une plaque de montage connectée au troisième motif sur la seconde face du premier substrat électriquement isolant (901), dans lequel, éventuellement, la plaque de montage comprend ou fait partie de : un article nécessitant un chauffage ou un refroidissement ; un bloc thermiquement conducteur ; ou un dispositif de transfert de chaleur tel qu'un dissipateur de chaleur ou un échangeur de chaleur.

15. Procédé de fabrication d'un module thermoélectrique (900) comprenant les étapes consistant à :
fournir un premier substrat électriquement isolant (901) présentant une première face et une seconde face opposée à la première face, dans lequel une première pluralité d'interconnexions électriques (902) est disposée selon un premier motif sur la première face et au moins une région de matériau métallique est disposée selon un troisième motif sur la seconde face du premier substrat électriquement isolant (901) ;
fournir un second substrat électriquement isolant (911) présentant une première face, dans lequel une seconde pluralité d'interconnexions électriques (910) est disposée selon un second motif sur la première face du second substrat électriquement isolant (911) ;
fournir une pluralité d'éléments thermoélectriques comprenant des éléments thermoélectriques de type n (904) et des éléments thermoélectriques de type p (903) ;
connecter une première extrémité de chaque élément thermoélectrique à une interconnexion de la première pluralité d'interconnexions électriques (902) ;
connecter une seconde extrémité de chaque élément thermoélectrique à une interconnexion de la seconde pluralité d'interconnexions électriques (910) ;
dans lequel les éléments thermoélectriques sont agencés pour former une première chaîne connectée en série d'éléments thermoélectriques de type n et de type p alternés et une seconde chaîne connectée en série d'éléments thermoélectriques de type n et de type p alternés, et au moins un élément thermoélectrique de type n ou de type p de la première chaîne connectée en série est connecté électriquement en parallèle avec un des éléments thermoélectriques du même type (type n ou type p) de la seconde chaîne connectée en série ;
dans lequel au moins une des connexions en parallèle se fait par l'intermédiaire d'une de la première pluralité d'interconnexions.
